(19) Europäisches Patentamt
European Patent Office
Office européen des brevets

(11) **EP 4 776 541 A1**

(12) **EUROPEAN PATENT APPLICATION**
published in accordance with Art. 153(4) EPC

(43) Date of publication:
**15.07.2026  Bulletin 2026/29**

(21) Application number: **24870268.0**

(22) Date of filing: **26.08.2024**

(51) International Patent Classification (IPC):
**H04L 1/00** (2006.01)

(52) Cooperative Patent Classification (CPC):
**H03M 13/09; H03M 13/15; H03M 13/29; H04L 1/00**

(86) International application number:
**PCT/CN2024/114419**

(87) International publication number:
**WO 2025/066722 (03.04.2025 Gazette 2025/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.09.2023  CN 202311295265**

(71) Applicant: **HUAWEI TECHNOLOGIES CO., LTD.
Shenzhen 518129 (CN)**

(72) Inventors:
• **HUANG, Qinhui
  Shenzhen, Guangdong 518129 (CN)**
• **YANG, Xiaoling
  Shenzhen, Guangdong 518129 (CN)**
• **MA, Huixiao
  Shenzhen, Guangdong 518129 (CN)**
• **HUANG, Kechao
  Shenzhen, Guangdong 518129 (CN)**

(74) Representative: **Pfenning, Meinig & Partner mbB
Patent- und Rechtsanwälte
Theresienhöhe 11a
80339 München (DE)**

(54) **DATA PROCESSING METHOD AND RELATED APPARATUS**

(57)    Embodiments of this application disclose a data processing method and a related apparatus. Specifically, for a first data stream that has undergone outer encoding, inner encoding is further performed on the first data stream to obtain a second data stream including at least one inner codeword. The inner encoding uses extended BCH encoding over $GF(2^8)$ with 2-bit error correction. Each inner codeword includes 119 information bits and 17 parity bits, totalling 136 bits, and the 17 parity bits include a 1-bit CRC extension parity bit. In other words, in embodiments of this application, single-bit extended BCH (136, 119) encoding with a 2-bit error correction capability is used. In an existing 400G ZR scenario, data padding and convolutional interleaving between outer encoding and inner encoding are implemented at a granularity of 119 bits. Therefore, the inner encoding scheme provided in embodiments of this application not only ensure compatibility with the 400G ZR scenario but also improves performance of concatenated coding.

| Transmitter device 01 | Attachment unit interface AUI | Transmitter processing module 02 | Channel transmission medium 03 | Receiver processing module 04 | Attachment unit interface AUI | Receiver device 05 |
|---|---|---|---|---|---|---|

FIG. 1

## Description

This application claims priority to Chinese Patent Application No. 202311295265.4, filed with the China National Intellectual Property Administration on September 28, 2023 and entitled "DATA PROCESSING METHOD AND RELATED APPARATUS", which is incorporated herein by reference in its entirety.

## TECHNICAL FIELD

Embodiments of this application relate to the field of optical communication, and in particular, to a data processing method and a related apparatus.

## BACKGROUND

Driven by continuous advancement of 5G, cloud computing, big data, artificial intelligence, and the like, optical communication systems and optical transport networks (optical transport networks, OTNs) are developing toward large capacity and ultra-high speeds. The use of forward error correction (forward error correction, FEC) encoding enables error correction for transmitted data, allowing original data sent from a transmitter to be recovered from received data despite transmission errors.

In 400G ZR scenarios, an optical module uses CFEC (Concatenated-FEC) as an error correction encoding scheme. In this scheme, a staircase code is used as an outer code, and a double-bit extended Hamming (hamming) code is used as an inner code. In future 1.6T ZR scenarios, due to the significant increase in transmission rates, performance of the existing CFEC scheme can no longer meet link budget requirements of the scenario. Therefore, a coding scheme with a higher coding gain is urgently needed.

## SUMMARY

Embodiments of this application provide a data processing method and a related apparatus, which not only ensures compatibility with a 400G ZR scenario but also improves performance of concatenated coding.

According to a first aspect, an embodiment of this application provides a data processing method. First, a first data stream that has undergone first forward error correction (forward error correction, FEC) encoding is obtained, where the first FEC encoding may be considered as outer encoding. Further, second FEC encoding is performed on every 119 consecutive bits in the first data stream to obtain one codeword, thereby generating a second data stream including at least one codeword. Each codeword includes 119 information bits and 17 parity bits, totalling 136 bits, the second FEC encoding uses extended BCH encoding over a finite field $GF(2^8)$ with 2-bit error correction, and the 17 parity bits include a 1-bit cyclic redundancy check (cyclic redundancy check, CRC) extension parity bit.

In this implementation, in this embodiment of this application, single-bit extended BCH (136, 119) encoding with an error correction capability of two bits is used. In an existing 400G ZR scenario, data padding and convolutional interleaving between outer encoding and inner encoding are implemented at a granularity of 119 bits. Therefore, an inner encoding scheme provided in this embodiment of this application is compatible with the 400G ZR scenario, and a Hamming code with an error correction capability of 1 bit may be replaced with a single-bit extended BCH code with an error correction capability of two bits or an extended code of the single-bit extended BCH code, thereby improving performance of concatenated coding.

In some possible implementations, after performing the second FEC encoding on the every 119 consecutive bits in the first data stream to obtain the one codeword, the method further includes: performing symbol mapping and polarization distribution on every eight consecutive bits in each codeword in the second data stream to obtain one dual-polarization (Dual-polarization, DP)-16QAM symbol, thereby obtaining a total of 17 DP-16QAM symbols. Any component of the DP-16QAM symbol is obtained through mapping of two consecutive bits in a same codeword. In this way, a quantity of bits with a high error probability is the same as a quantity of bits with a low error probability.

In some possible implementations, after performing symbol mapping and polarization distribution on the every eight consecutive bits in the codeword to obtain the one DP-16QAM symbol, the method further includes: obtaining a DP-16QAM symbol set, where the DP-16QAM symbol set includes L rows and 17 columns of DP-16QAM symbols, L is an integer greater than or equal to 1, and 17 DP-16QAM symbols in each row of the DP-16QAM symbol set are obtained by performing symbol mapping and polarization distribution on 136 bits in one codeword; and performing channel interleaving on the DP-16QAM symbol set to obtain a third data stream, where the third data stream includes 17 DP-16QAM symbol subsets, each DP-16QAM symbol subset includes L DP-16QAM symbols, each DP-16QAM symbol subset is from L DP-16QAM symbols of a corresponding column in the DP-16QAM symbol set, an $f^{th}$ DP-16QAM symbol subset in the third data stream corresponds to a DP-16QAM symbol in a $f^{th}$ column in the DP-16QAM symbol set, and $0 \leq f \leq 16$. It should be understood that, before a DP-16QAM symbol stream is sent to a channel for transmission, a capability of resisting a

**EP 4 776 541 A1**

channel burst error may be enhanced through channel interleaving.

In some possible implementations, bit padding is further performed on the first data stream that has undergone the first FEC encoding, where a quantity of padding bits is 119x6=714, and a quantity of 119-bit data blocks included in a total amount of padding data is an integer multiple of 16, so that convolutional interleaving synchronization and alignment can be more conveniently performed. This solution enables a new concatenated architecture to be better compatible with a 400G ZR data frame structure.

In some possible implementations, after the first FEC encoding is performed on the first data stream, convolutional interleaving is further performed, so that transfer of an error correlation between inner encoding and outer encoding can be reduced, and a burst error can be more effectively resisted.

In some possible implementations, the convolutional interleaving includes delaying, using 16 delay lines, bits from a data stream after the bit padding. Each delay line includes a different quantity of storage units. A delay line with a smallest quantity of storage units includes zero storage units. A difference in a quantity of storage units between every two adjacent delay lines is 2. Each storage unit is configured to store 119 bits. Input bits are sequentially input into the 16 delay lines based on sequence numbers of the 16 delay lines. Each delay line receives 119 bits per input and outputs 119 bits per output. Consecutive 16x119 bits output after the convolutional interleaving include the 119 bits output from each delay line. This implementation provides a specific implementation of the convolutional interleaving, and has a good practical effect.

In some possible implementations, the every 119 consecutive bits in the first data stream include 59 bit subsets and a target bit, each bit subset includes two bits, and performing the second FEC encoding on the every 119 consecutive bits in the first data stream to obtain the one codeword includes: performing exclusive OR on the two bits in each bit subset to obtain one bit, thereby obtaining a total of 59 bits; and encoding a bit sequence that includes the 59 bits and the target bit to obtain the 17 parity bits, where the 119 consecutive bits are information bits in the codeword. In this embodiment of this application, a manner of exclusive OR first and then encoding is used. For example, (136, 119) codeword processing may be implemented by using a (77, 60) encoder, so that encoding complexity is reduced without changing an inner codeword length and redundancy costs.

In some possible implementations, before obtaining the first data stream that has undergone first FEC encoding, the method further includes: performing data distribution on an input data stream to obtain four distributed data streams; and performing the first FEC encoding on each distributed data stream. This data method is used to be better compatible with a scenario with a throughput such as 1.6T, 800G, or 400G.

In some possible implementations, the first FEC encoding uses staircase (512, 510) encoding, and has a good practical effect.

According to a second aspect, an embodiment of this application provides a data processing apparatus. The data processing apparatus includes an obtaining unit and an encoding unit. The obtaining unit is configured to obtain a first data stream that has undergone first FEC encoding. The encoding unit is configured to perform second FEC encoding on every 119 consecutive bits in the first data stream to obtain one codeword, thereby generating a second data stream including at least one codeword. Each codeword includes 119 information bits and 17 parity bits, totalling 136 bits, the second FEC encoding uses extended BCH encoding over a finite field $GF(2^8)$ with 2-bit error correction, and the 17 parity bits include a 1-bit CRC extension parity bit.

In some possible implementations, the data processing apparatus further includes a mapping unit. The mapping unit is configured to perform symbol mapping and polarization distribution on every eight consecutive bits in each codeword in the second data stream to obtain one DP-16QAM symbol, thereby obtaining a total of 17 DP-16QAM symbols.

In some possible implementations, the data processing apparatus further includes a channel interleaving unit. The channel interleaving unit is configured to obtain a DP-16QAM symbol set, where the DP-16QAM symbol set includes L rows and 17 columns of DP-16QAM symbols, L is an integer greater than or equal to 1, and 17 DP-16QAM symbols in each row of the DP-16QAM symbol set are obtained by performing symbol mapping and polarization distribution on 136 bits in one codeword; and perform channel interleaving on the DP-16QAM symbol set to obtain a third data stream, where the third data stream includes 17 DP-16QAM symbol subsets, each DP-16QAM symbol subset includes L DP-16QAM symbols, each DP-16QAM symbol subset is from L DP-16QAM symbols of a corresponding column in the DP-16QAM symbol set, an $f^{th}$ DP-16QAM symbol subset in the third data stream corresponds to a DP-16QAM symbol in a $f^{th}$ column in the DP-16QAM symbol set, and $0 \leq f \leq 16$.

In some possible implementations, the data processing apparatus further includes a padding unit, and after the first FEC encoding is performed on the first data stream, bit padding performed by the padding unit is further performed, where a quantity of padding bits is 119x6=714.

In some possible implementations, the data processing apparatus further includes a convolutional interleaving unit, and after the bit padding is performed on the first data stream, convolutional interleaving performed by the convolutional interleaving unit is further performed.

In some possible implementations, the convolutional interleaving unit is specifically configured to delay, using 16 delay lines, bits from a data stream after the bit padding. Each delay line includes a different quantity of storage units. A delay line with a smallest quantity of storage units includes zero storage units. A difference in a quantity of storage units between every two adjacent delay lines is 2. Each storage unit is configured to store 119 bits. Input bits are sequentially input into the 16 delay lines based on sequence numbers of the 16 delay lines. Each delay line receives 119 bits per input and outputs 119 bits per output. Consecutive 16x119 bits output after the convolutional interleaving include the 119 bits output from each delay line.

In some possible implementations, the every 119 consecutive bits in the first data stream include 59 bit subsets and a target bit, each bit subset includes two bits, and the encoding unit is specifically configured to: perform an exclusive OR on the two bits in each bit subset to obtain one bit, thereby obtaining a total of 59 bits; and encode a bit sequence that includes the 59 bits and the target bit to obtain the 17 parity bits, where the 119 consecutive bits are information bits in the codeword.

In some possible implementations, the data processing apparatus further includes a processing unit. Before the first data stream that has undergone first FEC encoding is obtained, the processing unit is configured to: perform data distribution on an input data stream to obtain four distributed data streams; and perform the first FEC encoding on each distributed data stream.

In some possible implementations, the first FEC encoding uses staircase (512, 510) encoding.

According to a third aspect, an embodiment of this application provides a chip. The chip includes a processor and a memory, the memory and the processor are connected to each other through a line, the memory stores instructions, and the processor is configured to perform the method described in any one of the implementations in the first aspect.

According to a fourth aspect, an embodiment of this application provides a data transmission system. The data transmission system includes a data sending device and a data receiving device. The data sending device is configured to perform the method described in any one of implementations in the first aspect and send data to the data receiving device. The data receiving device is configured to perform an operation such as decoding on the received data.

According to a fifth aspect, an embodiment of this application provides a computer-readable storage medium. The computer-readable storage medium stores a computer program, and when the computer program is executed by a computer, the method described in any one of the implementations in the first aspect is implemented.

According to the foregoing technical solutions, it can be learned that embodiments of this application have the following advantages:

In this implementation, for a first data stream that has undergone outer encoding, inner encoding is further performed on the first data stream to obtain a second data stream including the at least one inner codeword. The inner encoding uses extended BCH encoding over $GF(2^8)$ with 2-bit error correction. An inner codeword includes 119 information bits and 17 parity bits, totalling 136 bits, and 17 parity bits include a 1-bit cyclic redundancy check (cyclic redundancy check, CRC) extension parity bit. In other words, in embodiments of this application, single-bit extended BCH (136, 119) encoding with an error correction capability of two bits is used. In an existing 400G ZR scenario, data padding and convolutional interleaving between outer encoding and inner encoding are implemented at a granularity of 119 bits. Therefore, an inner encoding scheme provided in embodiments of this application is compatible with the 400G ZR scenario and further improves performance of concatenated coding.

## BRIEF DESCRIPTION OF DRAWINGS

FIG. 1 is a diagram of a communication system to which an embodiment of this application is applied;
FIG. 2 is a diagram of another communication system to which an embodiment of this application is applied;
FIG. 3 is a diagram of an implementation of a transmitter data processor according to an embodiment of this application;
FIG. 4 is a schematic flowchart of a data processing method according to an embodiment of this application;
FIG. 5 is a diagram of a structure of an encoded data frame;
FIG. 6(a) is a diagram of a first implementation of convolutional interleaving according to an embodiment of this application;
FIG. 6(b) is a diagram of a second implementation of convolutional interleaving according to an embodiment of this application;
FIG. 7 is a diagram of an application scenario of inner encoding according to an embodiment of this application;
FIG. 8 is a diagram of an application scenario of channel interleaving according to an embodiment of this application;
FIG. 9 is a diagram of an implementation of a multi-lane parallel transmitter data processor according to an embodiment of this application;
FIG. 10 is a diagram of an implementation of data distribution according to an embodiment of this application;
FIG. 11 is a diagram of a structure of a data processing apparatus according to an embodiment of this application; and
FIG. 12 is a diagram of another structure of a data processing apparatus according to an embodiment of this application.

**DESCRIPTION OF EMBODIMENTS**

Embodiments of this application provide a data processing method and a related apparatus, which not only ensures compatibility with a 400G ZR scenario but also improves performance of concatenated coding. It should be noted that in the specification, claims, and the foregoing accompanying drawings of this application, the terms "first", "second", and the like are intended to distinguish between similar objects but do not limit a specific order or sequence. It should be understood that the foregoing terms may be interchanged in proper cases, so that embodiments described in this application can be implemented in an order other than the content described in this application. In addition, the terms "include", "have", and any other variant thereof are intended to cover a non-exclusive inclusion. For example, a process, method, system, product, or device that includes a list of steps or units is not necessarily limited to those expressly enumerated steps or units, but may include other steps or units not expressly enumerated or inherent to such a process, method, product, or device.

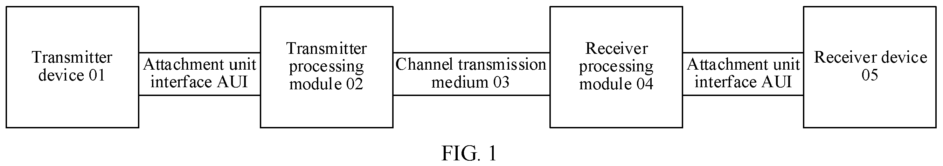

FIG. 1 is a diagram of a communication system to which an embodiment of this application is applied. As shown in FIG. 1, the communication system includes a transmitter device 01, a transmitter processing module 02, a channel transmission medium 03, a receiver processing module 04, and a receiver device 05. For example, the communication system is a data center network. The transmitter device 01 and the receiver device 05 may be devices such as a switch or a router, the transmitter device 01 is also referred to as a host chip (host chip) located at a transmitter, the receiver device 05 is also referred to as a host chip located at a receiver, and the channel transmission medium 03 may be an optical fiber. The host chip is also sometimes referred to as a host device (host device). The transmitter device 01 may be connected to the transmitter processing module 02 through an attachment unit interface (attachment unit interface, AUI), and the receiver device 05 may be connected to the receiver processing module 04 through an AUI. The transmitter processing module 02 and the receiver processing module 04 may each be an optical module (optical module), an electrical module, a connector (connector), or another module that processes data in a data sending process. For example, the processing module may be an 800 ZR module (800 ZR module, which is a coherent optical module). In addition, the transmitter device 01, the transmitter processing module 02, the channel transmission medium 03, the receiver processing module 04, and the receiver device 05 in the communication system may all support bidirectional transmission or unidirectional transmission. This is not specifically limited herein.

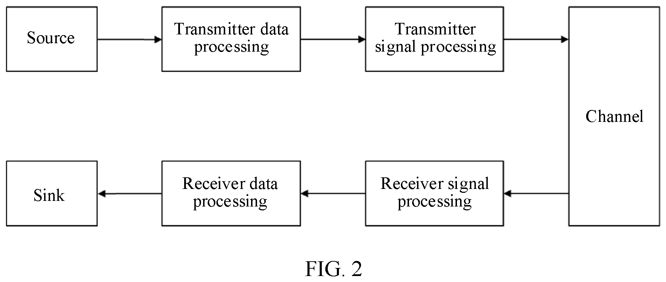

FIG. 2 is a diagram of another communication system to which an embodiment of this application is applied. As shown in FIG. 2, at a transmitter, a source provides a to-be-sent data stream. A transmitter data processor receives the data stream, performs data processing including encoding, interleaving, and modulation on the data stream to obtain a symbol data stream, and sends the symbol data stream to a transmitter signal processor for framing, and transmits a signal to a receiving device through a channel. After receiving a signal that is distorted due to noise or other impairments on the channel, the receiving device sends the signal to a receiver signal processor for dispersion compensation, synchronization, phase recovery, and other operations. Then, the signal is sent to the receiver data processor for performing demodulation, de-interleaving, and decoding, to restore original data, and send the data to a sink. Transmitter data processing and transmitter signal processing shown in FIG. 2 may be applied to the transmitter processing module 02 shown in FIG. 1, and receiver data processing and receiver signal processing shown in FIG. 2 may be applied to the receiver processing module 04 shown in FIG. 1.

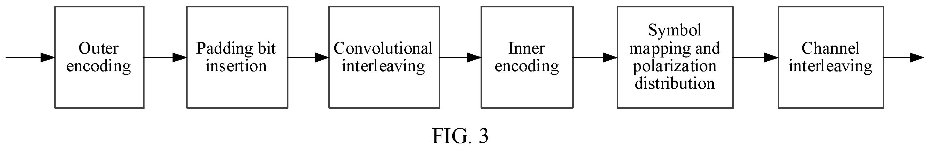

FIG. 3 is a diagram of an implementation of a transmitter data processor according to an embodiment of this application. As shown in FIG. 3, the transmitter data processor sequentially performs operations such as outer encoding, padding bit insertion, convolutional interleaving, inner encoding, symbol mapping, polarization distribution, and channel interleaving on an input data stream. It should be understood that, during actual application, an operation performed by the transmitter data processor includes but is not limited to an operation shown in FIG. 3. For example, before convolutional interleaving is performed, an encoded data frame obtained by performing outer encoding may be further scrambled.

It should be understood that the "inner" in an inner code and the "outer" in an outer code are distinguished based merely on a distance between a channel transmission medium and an execution body that performs an operation on data. An execution body that performs an operation on the inner code is closer to the channel transmission medium, and an execution body that performs an operation on the outer code is farther away from the channel transmission medium. In this embodiment of this application, FIG. 1 is used as an example. Because the transmitter processing module 02 sequentially encodes data twice and then sends the encoded data to the channel transmission medium, data that is first encoded by the transmitter processing module 02 is farther away from the channel transmission medium, and data that is later encoded by the transmitter processing module 02 is closer to the channel transmission medium. In this way, the data that is first encoded by the transmitter processing module 02 is referred to as outer encoded data, and the data that is later encoded by the transmitter processing module 02 is referred to as inner encoded data. Correspondingly, data that is first decoded by the receiver processing module 04 is referred to as inner decoded data, and data that is later decoded by the receiver processing module 04 is referred to as outer decoded data. In a possible implementation, both the inner encoding and the outer encoding use an FEC encoding scheme, so as to form a concatenated FEC transmission scheme. For example, the transmitter processing module 02 may perform outer encoding by using a staircase code, perform inner encoding by using a Hamming (Hamming) code, or perform inner encoding by using a Bose-Chaudhuri-Hocquenghem (Bose-Chaudhuri-Hocquenghem, BCH) code.

It should be noted that the foregoing content is example description of an application scenario of the data processing method provided in embodiments of this application, and does not constitute any limitation on application scenarios of the data processing method. A person of ordinary skill in the art may learn that, as a service requirement changes, the application scenario of the data processing method may be adjusted based on an application requirement. Application scenarios are not listed one by one in embodiments of this application. The following mainly describes a data processing method applied to a data transmitter. A data processing method applied to a receiver may be understood as an inverse operation of the data processing method of the transmitter. With the data processing method of the transmitter determined, the data processing method of the receiver is also clear. Therefore, the data processing method of the receiver is not described in detail in this application.

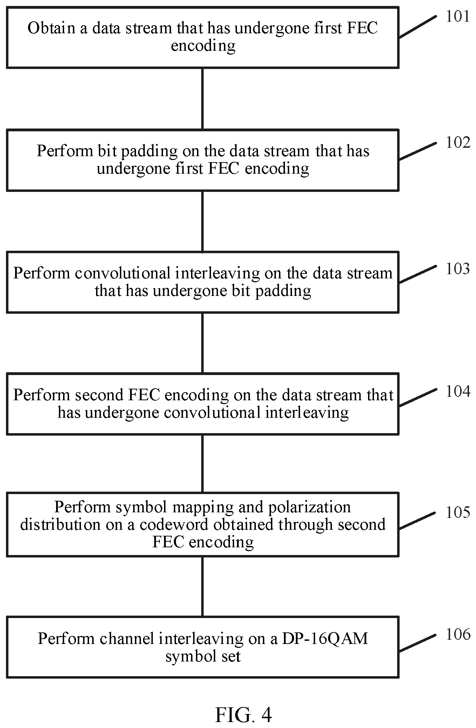

FIG. 4 is a schematic flowchart of a data processing method according to an embodiment of this application. The data processing method includes the following steps, which are described in detail below. It should be understood that, for ease of description, first FEC encoding in the following may be considered as outer encoding described above, and second FEC encoding in the following may be considered as inner encoding described above. The following may be understood based on this.

101: Obtain a data stream that has undergone first FEC encoding.

It should be understood that a specific implementation of the outer encoding is not limited in this application. In an example, the outer encoding may specifically use staircase (512, 510) encoding. In some possible scenarios, an outer encoded data stream may also be referred to as an encoded data frame, and bits in the encoded data frame are distributed in rows and columns.

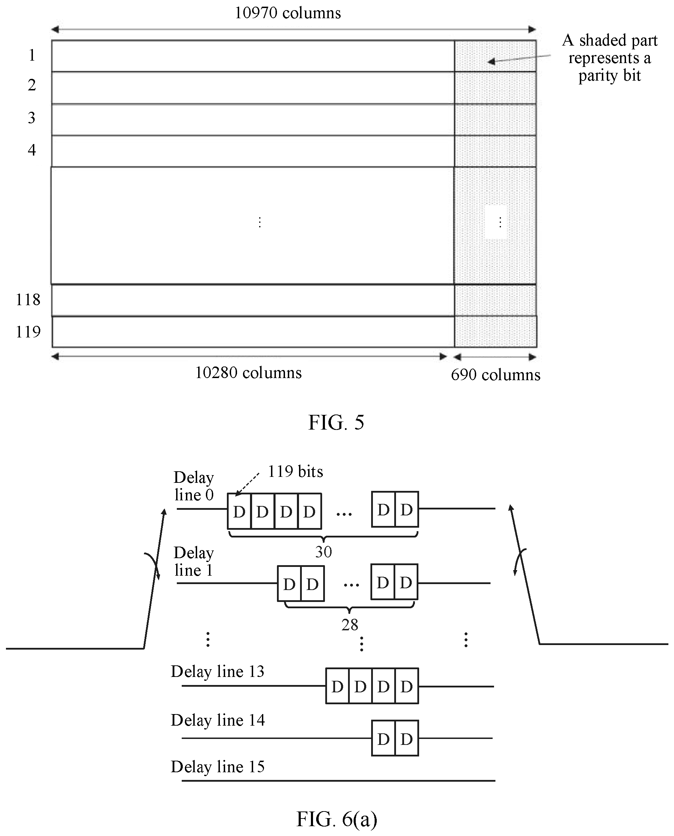

FIG. 5 is a diagram of a structure of an encoded data frame. As shown in FIG. 5, the encoded data frame includes 119 rows and 10970 columns of bits. 119 rows and 10280 columns of bits are information bits of the encoded data frame, and 119 rows and 690 columns of bits are parity bits of the encoded data frame.

102: Perform bit padding on the data stream that has undergone first FEC encoding.

In this embodiment of this application, bit padding is performed on the outer encoded data stream (encoded data frame), and specifically, 119x6=714 bits are padded. A value of the padding bit is not limited in this application. For example, all the padding bits may be 0s. In a possible implementation, the padding bit is added to the end of the encoded data frame.

103: Perform convolutional interleaving on the data stream that has undergone bit padding.

Specifically, convolutional interleaving is performed on the data stream that has undergone bit padding, thereby generating a data stream whose data sequence is disordered. The following describes possible implementations of the convolutional interleaving.

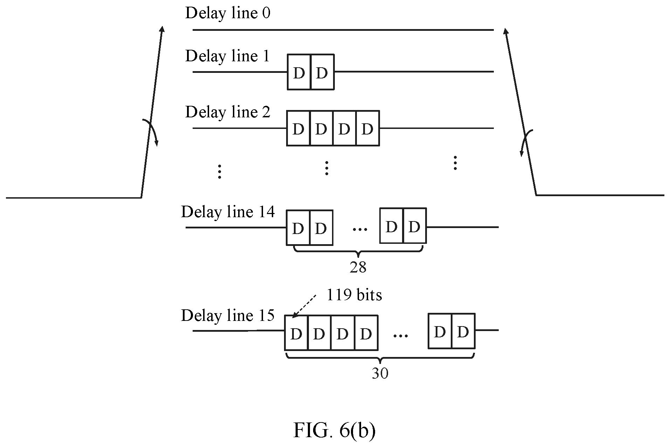

FIG. 6(a) is a diagram of a first implementation of convolutional interleaving according to an embodiment of this application. FIG. 6(b) is a diagram of a second implementation of convolutional interleaving according to an embodiment of this application. As shown in FIG. 6(a) and FIG. 6(b), a convolutional interleaver includes 16 delay lines (delay line), and the convolutional interleaver delays input data based on the 16 delay lines. Each delay line includes a different quantity of storage units. A delay line with a smallest quantity of storage units includes zero storage units, a difference in a quantity of storage units between every two adjacent delay lines is 2, and each storage unit is configured to store 119 bits. Bits in a first bit set are sequentially input into the 16 delay lines based on sequence numbers of the 16 delay lines, Each delay line receives 119 bits per input and outputs 119 bits per output, and consecutive 16x119 bits output after the convolutional interleaving include the 119 bits output from each delay line. For example, the 16 delay lines respectively include zero storage units, two storage units, four storage units, ..., 30 storage units, and each storage unit is configured to store 119 symbols. In this case, the 16 delay lines respectively correspond to 16 delay values, and the delay values include zero bits, 2x119 bits, 4x119 bits, ..., 30x119 bits. It may also be understood as that an interleaving depth of the convolutional interleaver is 16. It should be noted that, in this application, a delay value is measured in bits. A larger quantity of bits included in a delay value of a delay line indicates a longer delay (also referred to as latency) of the delay line for data. It should be understood that, when the delay line includes no storage unit, a delay caused by the delay line is zero symbols, that is, transparent transmission without a delay is performed.

As shown in FIG. 6(a), quantities of the storage units in the 16 delay lines sequentially decrease based on the sequence numbers of the 16 delay lines. In other words, the delay line 0 has 30 storage units, two storage units are sequentially reduced for each delay line, and the delay line 15 has zero storage units. As shown in FIG. 6(b), quantities of the storage units in the 16 delay lines sequentially increase based on the sequence numbers of the 16 delay lines. In other words, the delay line 0 has zero storage units, two storage units are sequentially added for each delay line, and the delay line 15 has 30 storage units.

It should be noted that, at a same moment, input and output switches (switch) of the convolutional interleaver are in a same delay line. After a current delay line receives 119 bits per input and outputs 119 bits per output, positions of the switches are updated to a next delay line, to ensure that the bits in the first bit set are sequentially input into the 16 delay lines based on the sequence numbers of the 16 delay lines, and consecutive 16x119 bits output after the convolutional interleaving include the 119 bits output from each delay line. A specific data read/write operation performed by the convolutional interleaver is as follows: 119 bits are read from a storage unit that is closest to an output port and that is in the current delay line. 119 bits stored in each storage unit in the current delay line are transferred to a next storage unit. Next, the 119 bits are written into a storage unit that is closest to an input port and that is in the current delay line. Then, updating to a next delay line is performed, and the foregoing operations are repeated. The rest can be deduced by analogy.

It should be understood that convolutional interleaving processing in FIG. 6(a) and convolutional interleaving processing in FIG. 6(b) are inverse operations of each other. In other words, when a transmitter processing module uses a convolutional interleaving structure shown in FIG. 6(a), the structure shown in FIG. 6(b) is used for convolutional de-interleaving corresponding to a receiver processing module that corresponds to the transmitter processing module. Similarly, when the transmitter processing module uses the convolutional interleaving structure shown in FIG. 6(b), the structure shown in FIG. 6(a) is used for convolutional de-interleaving corresponding to a receiver processing module that corresponds to the transmitter processing module.

104: Perform second FEC encoding on the data stream that has undergone convolutional interleaving.

Specifically, inner encoding is performed on every 119 consecutive bits in the data stream that has undergone convolutional interleaving to obtain one inner codeword. Each inner codeword includes 119 information bits and 17 parity bits, totalling 136 bits. In this embodiment of this application, the inner encoding may specifically use single-bit extended (extended) BCH encoding over $GF(2^8)$ with 2-bit error correction, enhancing an error correction capability of the inner codeword to two bits and improving performance of concatenated coding. The 17 parity bits in the inner codeword include a 1-bit cyclic redundancy check (cyclic redundancy check, CRC) extension parity bit, and therefore, the inner encoding is referred to as single-bit extended BCH encoding. GF refers to a finite field, and may also be referred to as a Galois field (Galois field), and $2^8$ represents an order of the finite field.

It should be noted that a BCH code is an algebraic block code constructed in a finite field $GF(2^m)$, and a quantity of parity bits in the BCH code is equal to $m \times t$, where t indicates an error correction capability of the BCH code in t bits. Therefore, for each 1-bit increase in the error correction capability, an additional of overhead of m bits is incurred. As t increases, the performance gain from further increasing t gradually reduces. Because soft-decision decoding is used for BCH encoding, decoding complexity of BCH encoding with t>2 increases exponentially when compared with that of BCH encoding with t=2. In contrast, BCH encoding with t=2 introduces only a slight increase in encoding and decoding complexity compared with hamming encoding. In conclusion, in this embodiment of this application, BCH encoding with a 2-bit error correction capability is selected as inner encoding.

It should be further noted that, in a 400G ZR scenario, bit padding and convolutional interleaving between inner encoding and outer encoding are performed at a granularity of 119 bits. To maintain backward compatibility, in this embodiment of this application, the information length of an inner codeword is kept as 119 bits, denoted by k. During BCH encoding, incorrect decision may occur during decoding. That is, a received sequence is determined as a valid but incorrect codeword. This can lead to error propagation, thereby affecting decoding performance. A probability of error detection depends on a minimum distance between inner codewords. A probability of error propagation can be reduced by adding a CRC extension parity bit to the inner codeword. Assuming that r represents a quantity of bits of CRC extension parity bits, a length of the inner codeword is: $n = k + m \times t + r = 119 + 2m + r$. Further, based on a characteristic of the BCH encoding, the length of the inner codeword needs to meet the following condition: $119 + 2 \times m + 1 \leq 2^m - 1$. According to the foregoing two formulas, it may be learned that m is an integer greater than or equal to 8. The inner codeword is finally mapped to a dual-polarization (Dual-polarization, DP)-16QAM symbol in groups of eight bits. To simplify subsequent symbol mapping, in this embodiment of this application, the length n of the inner codeword is selected to be a multiple of 8. It may be obtained with reference to the foregoing two formulas that $(2m + r)\%8 = 1$, where $m \geq 8$, and a%b represents a modulo operation on a by b. As m and r increase, complexity and overhead of the codeword also increase. Therefore, minimum m and r that meet the foregoing relationship should be selected, that is, m=8 and r=1. In addition, for the inner codeword, when r>1, the marginal benefit of further increasing r in reducing the error detection probability becomes very limited. Therefore, in this embodiment of this application, m=8 and r=1 are selected, employing single-bit extended BCH encoding (136, 119) over $GF(2^8)$ with 2-bit error correction as inner encoding.

The inner codeword is generated by shortening BCH encoding (255, 239) over $GF(2^8)$ by 120 bits and then appending a single-bit parity bit. A generator polynomial of the inner codeword may be represented as:

$$g(x) = M1(x)M3(x)$$
$$= (x^8 + x^4 + x^3 + x^2 + 1)(x^8 + x^6 + x^5 + x^4 + x^2 + x + 1)(x + 1)$$
$$= x^{16} + x^{14} + x^{13} + x^{11} + x^{10} + x^9 + x^8 + x^6 + x^5 + x + 1$$

Here, M1(x) and M3(x) respectively correspond to minimum polynomials of elements $\alpha^1$ and $\alpha^3$ *of* $GF(2^8)$, where

$\alpha$ is a primitive element of the finite field GF($2^8$). 119 bits of an information sequence are used as coefficients of a polynomial whose highest degree is 118, forming an information polynomial m(x). A remainder polynomial r(x) is obtained, using modulo-2 division, by dividing $x^{17}$m(x) by g(x), and coefficients of items in r(x) are a parity sequence P[0:16]. Finally, the information sequence and the parity sequence form an inner codeword (136, 119), which is denoted as C[0:135]= [$c_0$, $c_1$, ... , $c_{135}$] and may be represented as

$$\begin{cases} c_i = a_i, & i \in [0,118] \\ c_i = p_{i-119}, & i \in [119,135] \end{cases}.$$

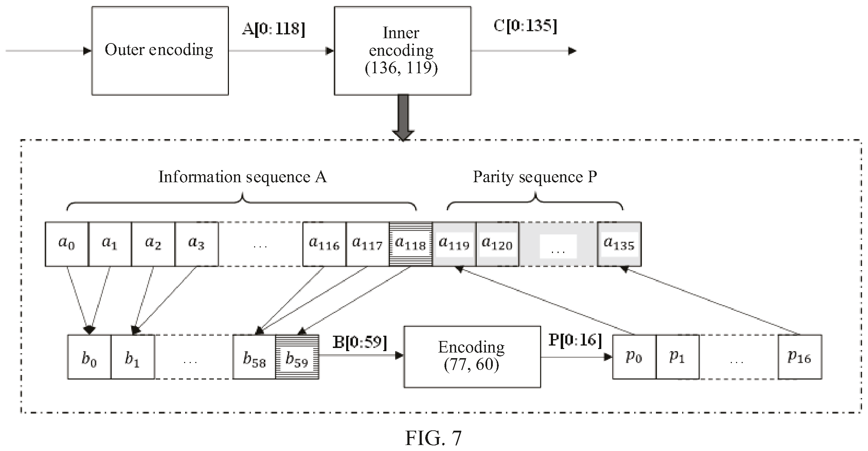

FIG. 7 is a diagram of an application scenario of inner encoding according to an embodiment of this application. As shown in FIG. 7, 118 bits are selected from a 119-bit information sequence A[0:118] to form a sequence A', denoted as $A' = [a'_0, a'_1, \ldots a'_{117}]$ . A' may be any 118 bits from the information sequence A. To facilitate subsequent channel interleaving and modulation, the first 118 bits from the information sequence A may be selected as A', that is, A' = [$a_0$, $a_1$, ... $a_{117}$]. Then, two adjacent bits in A' are grouped together, and an exclusive OR operation is performed to obtain 59 bits [$b_0$, $b_1$, ... , $b_{58}$]. In addition, the bit from the information sequence A not selected into A', denoted as A\A', bypasses the grouping and exclusive OR operations, and is combined with $b_0$- $b_{57}$ to form a to-be-encoded sequence B[0:59]=[$b_0$, $b_1$, ... , $b_{59}$], which is represented as follows: $\begin{cases} b_i = a'_{2i} \wedge a'_{2i+1}, i \in [0,58] \\ b_i = A\backslash A', & i = 59 \end{cases}$ . The to-be-encoded sequence B[0:59] is generated, and then BCH (77, 60) encoding is performed on the to-be-encoded sequence B to generate 17 parity bits [$p_0$, $p_1$, ... , $p_{16}$]. BCH (77, 60) is generated by shortening BCH (255, 239) over GF($2^8$) by 179 bits and then appending a single-bit parity bit. A generator polynomial g(x) of the BCH (77, 60) is the same as the foregoing polynomial g(x). To-be-encoded 60 bits are used as coefficients of a polynomial with a highest degree of 59, forming an information polynomial m(x). A remainder polynomial r(x) is obtained, using modulo-2 division, by dividing $x^{17}$m(x) by g(x), and coefficients of items in r(x) are a parity sequence P[0:16]. Finally, the information sequence A and a parity sequence P form an inner codeword (136, 119), which is denoted as C[0:135]= [$c_0$, $c_1$, ... , $c_{135}$] and may be represented as: $\begin{cases} c_i = a_i, & i \in [0,118] \\ c_i = p_{i-119}, & i \in [119,135] \end{cases}.$

It can be learned that, in this embodiment of this application, a manner of exclusive OR followed by encoding is used. For example, (136, 119) codeword processing may be implemented by using a (77, 60) encoder, reducing encoding complexity without changing an inner codeword length and redundancy overhead.

105: Perform symbol mapping and polarization distribution on a codeword obtained through second FEC encoding.

Specifically, symbol mapping and polarization distribution are performed on every eight consecutive bits in an inner codeword to obtain one DP-16QAM symbol. Because an inner code length is now 136 bits, each codeword is mapped into 17 DP-16QAM symbols during symbol mapping and polarization distribution. Among the eight bits involved in symbol mapping and polarization distribution, every two bits are used as a group and mapped to one of the four components of a DP-16QAM symbol: X-polarization I (in-phase), X-polarization Q (quadrature-phase), Y-polarization I (in-phase), and Y-polarization Q (quadrature-phase). The X-polarization and the Y-polarization are orthogonal to each other. Considering that each component of a DP-16QAM symbol is mapped from two bits in an inner codeword, and because a binary bit DP-16QAM symbol uses Gray mapping, error probabilities for two bits mapped to any component of the DP-16QAM symbol are not equal. To improve performance of concatenated coding, any component of the DP-16QAM symbol is mapped from two consecutive bits in a same codeword. In this way, a quantity of bits with a high error probability is the same as a quantity of bits with a low error probability.

106: Perform channel interleaving on a DP-16QAM symbol set.

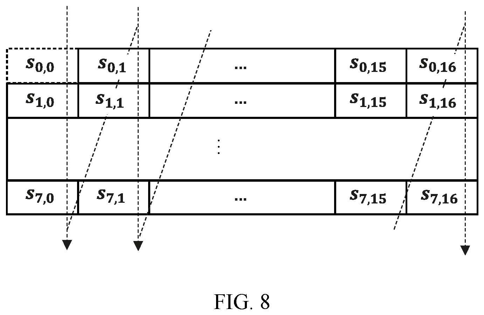

FIG. 8 is a diagram of an application scenario of channel interleaving according to an embodiment of this application. As shown in FIG. 8, using a DP-16QAM symbol set that includes 8x17 DP-16QAM symbols and that is obtained by mapping eight inner codewords as an example, the DP-16QAM symbol set is arranged as DP-16QAM symbols in 8 rows and 17 columns. The DP-16QAM symbols in the DP-16QAM symbol set are denoted as {$s_{i,j}$}, which represents a $j$th DP-16QAM symbol mapping from an $i$th inner codeword, where 0≤i≤7, and 0≤j≤16. In a channel interleaving manner provided in embodiments of this application, row-column interleaving is completed at a granularity of DP-16QAM symbols. To be specific, DP-16QAM symbols, after channel interleaving, are sequentially output column by column, with the symbols within each column output sequentially from a row 0 to a row 7. FIG. 8 is used as an example. An output sequence of the DP-16QAM symbols after channel interleaving is: {$s_{0,0}$}-{$s_{7,0}$} from a column 0 are sequentially output, followed by {$s_{0,1}$}-{$s_{7,1}$} from a column 1 sequentially, ..., then {$s_{0,15}$}-{$s_{7,15}$} from a column 15 sequentially, and finally {$s_{0,16}$}-{$s_{7,16}$} from a column 16 sequentially.

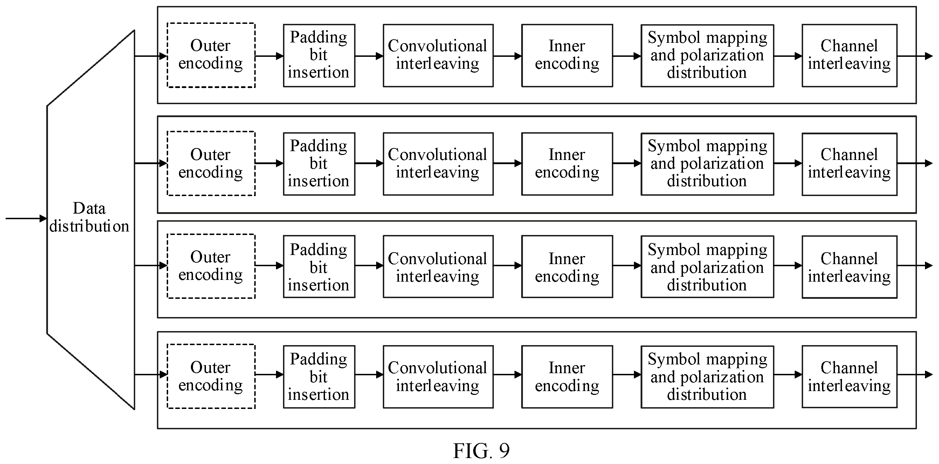

The foregoing describes the data processing method provided in embodiments of this application. It should be understood that, in some possible scenarios, considering that an FEC scheme may need to be compatible with throughput rates such as 1.6T, 800G, and 400G, as well as the hardware implementation challenges at ultra-high throughput rates, a multi-lane parallel data processing scheme may also be proposed based on the foregoing embodiments. FIG. 9 is a diagram of an implementation of a multi-lane parallel transmitter data processor according to an embodiment of this application. As shown in FIG. 9, an input data stream is first distributed to obtain four data streams, and then each of these distributed data streams is then processed according to the data processing manner shown in FIG. 3.

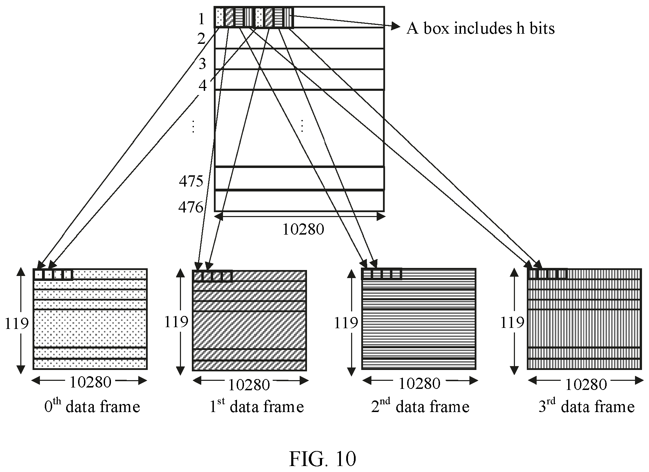

FIG. 10 is a diagram of an implementation of data distribution according to an embodiment of this application. As shown in FIG. 10, a block of consecutive data with a size of 4x119x10280 bits is first obtained, and this data block is then distributed cyclically in a round-robin manner at a granularity of h bits, resulting in four data frames. Bits in each data frame are arranged in 119 rows and 10280 columns. Outer encoding may be performed on the four data frames to obtain four encoded data frames, which are then processed according to the manner shown in FIG. 3. It should be understood that 10280%(4xh)=0, where h can be, for example, 1, 257, 514, or 1285. This scheme provides better compatibility with various throughput rates such as 1.6T, 800G, and 400G. In an example, when an input data frame carries 1.6T data, the data frame may be distributed to four lanes for processing, as shown in FIG. 9. In another example, when the input data frame carries 800G traffic, the data frame may be distributed to two lanes for processing, and the other two lanes are disabled to reduce power consumption. In still another example, when the input data frame carries 400G traffic, data frame distribution may be omitted, data processing shown in FIG. 3 is directly performed on the data frame, and the other three lanes are disabled to reduce power consumption.

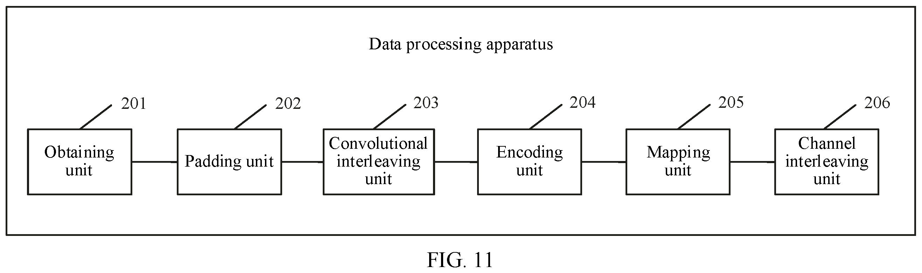

FIG. 11 is a diagram of a structure of a data processing apparatus according to an embodiment of this application. As shown in FIG. 11, the data processing apparatus includes an obtaining unit 201, a padding unit 202, a convolutional interleaving unit 203, an encoding unit 204, a mapping unit 205, and a channel interleaving unit 206. The obtaining unit 201 is configured to perform an operation of step 101, the padding unit 202 is configured to perform an operation of step 102, the convolutional interleaving unit 203 is configured to perform an operation of step 103, the encoding unit 204 is configured to perform an operation of step 104, the mapping unit 205 is configured to perform an operation of step 105, and the channel interleaving unit 206 is configured to perform an operation of step 106. It should be understood that the data processing apparatus provided in this application may also be implemented in another manner. For example, division into the units in the foregoing apparatus is merely logical function division and may be another division in actual implementation. For example, a plurality of units or components may be combined or integrated into another system. In addition, functional units in embodiments of this application may be integrated into one processing unit, may be independent physical units, or two or more functional units may be integrated into one processing unit. The integrated unit may be implemented in a form of hardware, or may be implemented in a form of a software functional unit.

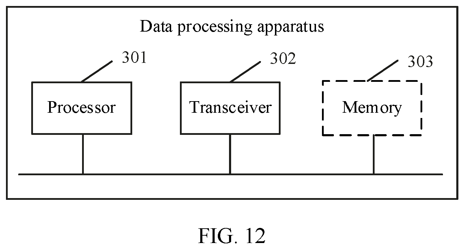

FIG. 12 is a diagram of another structure of a data processing apparatus according to an embodiment of this application. As shown in FIG. 12, the data processing apparatus includes a processor 301 and a transceiver 302. The processor 301 and the transceiver 302 are interconnected through a line. Specifically, the transceiver 302 is configured to perform a data sending and receiving operation, and the processor 301 is configured to perform another operation than data sending and receiving. In a possible implementation, the processor 301 may include the padding unit 202, the convolutional interleaving unit 203, the encoding unit 204, the mapping unit 205, and the channel interleaving unit 206 shown in FIG. 11, and the transceiver 302 includes the obtaining unit 201 shown in FIG. 11. Optionally, the data processing apparatus may further include a memory 303. The memory 303 is configured to store program instructions and data.

An embodiment of this application further provides a chip. The chip integrates a circuit and one or more interfaces that are configured to implement a function of the processor 301. When a memory is integrated into the chip, the chip may complete the method steps in any one or more of the foregoing embodiments. When no memory is integrated into the chip, the chip may be connected to an external memory through an interface. The chip implements, based on program code stored in the external memory, actions performed by the transmitter device or the receiver device in the foregoing embodiments.

Finally, it should be noted that the foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A data processing method, comprising:

   obtaining a first data stream that has undergone first forward error correction FEC encoding; and
   performing second FEC encoding on every 119 consecutive bits in the first data stream to obtain one codeword, thereby generating a second data stream comprising at least one codeword, wherein each codeword comprises 119 information bits and 17 parity bits, totalling 136 bits, the second FEC encoding uses extended BCH encoding over a finite field $GF(2^8)$ with 2-bit error correction, and the 17 parity bits comprise a 1-bit cyclic redundancy check CRC extension parity bit.

2. The method according to claim 1, wherein after performing the second FEC encoding on the every 119 consecutive bits in the first data stream to obtain the one codeword, the method further comprises:
performing symbol mapping and polarization distribution on every eight consecutive bits in each codeword in the second data stream to obtain one dual-polarization-16QAM DP-16QAM symbol, thereby obtaining a total of 17 DP-16QAM symbols.

3. The method according to claim 2, wherein after performing symbol mapping and polarization distribution on the every eight consecutive bits in the codeword to obtain the one DP-16QAM symbol, the method further comprises:

obtaining a DP-16QAM symbol set, wherein the DP-16QAM symbol set comprises L rows and 17 columns of DP-16QAM symbols, L is an integer greater than or equal to 1, and 17 DP-16QAM symbols in each row of the DP-16QAM symbol set are obtained by performing symbol mapping and polarization distribution on 136 bits in the codeword; and
performing channel interleaving on the DP-16QAM symbol set to obtain a third data stream, wherein the third data stream comprises 17 DP-16QAM symbol subsets, each DP-16QAM symbol subset comprises L DP-16QAM symbols, each DP-16QAM symbol subset is from L DP-16QAM symbols of a corresponding column in the DP-16QAM symbol set, an $f^{th}$ DP-16QAM symbol subset in the third data stream corresponds to a DP-16QAM symbol in a $f^{th}$ column in the DP-16QAM symbol set, and $0 \leq f \leq 16$.

4. The method according to any one of claims 1 to 3, wherein bit padding is further performed on the first data stream that has undergone the first FEC encoding, wherein a quantity of padding bits is 119x6=714.

5. The method according to claim 4, wherein after the bit padding is performed on the first data stream, convolutional interleaving is further performed.

6. The method according to claim 5, wherein the convolutional interleaving comprises:
delaying, using 16 delay lines, bits from a data stream after the bit padding, wherein each delay line comprises a different quantity of storage units, a delay line with a smallest quantity of storage units comprises zero storage units, a difference in a quantity of storage units between every two adjacent delay lines is 2, each storage unit is configured to store 119 bits, input bits are sequentially input into the 16 delay lines based on sequence numbers of the 16 delay lines, each delay line receives 119 bits per input and outputs 119 bits per output, and consecutive 16x119 bits output after the convolutional interleaving comprise the 119 bits output from each delay line.

7. The method according to any one of claims 1 to 6, wherein the every 119 consecutive bits in the first data stream comprise 59 bit subsets and a target bit, each bit subset comprises two bits, and performing the second FEC encoding on the every 119 consecutive bits in the first data stream to obtain the one codeword comprises:

performing exclusive OR on the two bits in each bit subset to obtain one bit, thereby obtaining a total of 59 bits; and
encoding a bit sequence that comprises the 59 bits and the target bit to obtain the 17 parity bits, wherein the 119 consecutive bits are information bits in the codeword.

8. The method according to any one of claims 1 to 7, wherein before obtaining the first data stream that has undergone the first FEC encoding, the method further comprises:

performing data distribution on an input data stream to obtain four distributed data streams; and
performing the first FEC encoding on each distributed data stream.

9. The method according to any one of claims 1 to 8, wherein the first FEC encoding uses staircase (512, 510) encoding.

10. A data processing apparatus, comprising an obtaining unit and an encoding unit, wherein

the obtaining unit is configured to obtain a first data stream that has undergone first forward error correction FEC encoding; and

the encoding unit is configured to perform second FEC encoding on every 119 consecutive bits in the first data stream to obtain one codeword, thereby generating a second data stream comprising at least one codeword, wherein each codeword comprises 119 information bits and 17 parity bits, totalling 136 bits, the second FEC encoding uses extended BCH encoding over a finite field $GF(2^8)$ with 2-bit error correction, and the 17 parity bits comprise a 1-bit cyclic redundancy check CRC extension parity bit.

11. The data processing apparatus according to claim 10, wherein the data processing apparatus further comprises a mapping unit; and

the mapping unit is configured to perform symbol mapping and polarization distribution on every eight consecutive bits in each codeword in the second data stream to obtain one dual-polarization-16QAM DP-16QAM symbol, thereby obtaining a total of 17 DP-16QAM symbols.

12. The data processing apparatus according to claim 11, wherein the data processing apparatus further comprises a channel interleaving unit, wherein

the channel interleaving unit is configured to obtain a DP-16QAM symbol set, wherein the DP-16QAM symbol set comprises L rows and 17 columns of DP-16QAM symbols, L is an integer greater than or equal to 1, and 17 DP-16QAM symbols in each row of the DP-16QAM symbol set are obtained by performing symbol mapping and polarization distribution on 136 bits in one codeword; and

perform channel interleaving on the DP-16QAM symbol set to obtain a third data stream, wherein the third data stream comprises 17 DP-16QAM symbol subsets, each DP-16QAM symbol subset comprises L DP-16QAM symbols, each DP-16QAM symbol subset is from L DP-16QAM symbols of a corresponding column in the DP-16QAM symbol set, an $f^{th}$ DP-16QAM symbol subset in the third data stream corresponds to a DP-16QAM symbol in a $f^{th}$ column in the DP-16QAM symbol set, and $0 \leq f \leq 16$.

13. The data processing apparatus according to any one of claims 10 to 12, wherein the data processing apparatus further comprises a padding unit, and bit padding performed by the padding unit is further performed on the first data stream that has undergone the first FEC encoding, wherein a quantity of padding bits is 119x6=714.

14. The data processing apparatus according to claim 13, wherein the data processing apparatus further comprises a convolutional interleaving unit, and after the bit padding is performed on the first data stream, convolutional interleaving performed by the convolutional interleaving unit is further performed.

15. The data processing apparatus according to claim 14, wherein the convolutional interleaving unit is specifically configured to:
delay, using 16 delay lines, bits from a data stream after the bit padding, wherein each delay line comprises a different quantity of storage units, a delay line with a smallest quantity of storage units comprises zero storage units, a difference in a quantity of storage units between every two adjacent delay lines is 2, each storage unit is configured to store 119 bits, input bits are sequentially input into the 16 delay lines based on sequence numbers of the 16 delay lines, each delay line receives 119 bits per input and outputs 119 bits per output, and consecutive 16x119 bits output after the convolutional interleaving comprise the 119 bits output from each delay line.

16. The data processing apparatus according to any one of claims 10 to 15, wherein the every 119 consecutive bits in the first data stream comprise 59 bit subsets and a target bit, each bit subset comprises two bits, and the encoding unit is specifically configured to:

perform exclusive OR on the two bits in each bit subset to obtain one bit, thereby obtaining a total of 59 bits; and encode a bit sequence that comprises the 59 bits and the target bit to obtain the 17 parity bits, wherein the 119 consecutive bits are information bits in the codeword.

17. The data processing apparatus according to any one of claims 10 to 16, wherein the data processing apparatus further comprises a processing unit, and before the first data stream that has undergone first FEC encoding is obtained, the processing unit is configured to:

perform data distribution on an input data stream to obtain four distributed data streams; and perform the first FEC encoding on each distributed data stream.

18. The data processing apparatus according to any one of claims 10 to 17, wherein the first FEC encoding uses staircase (512, 510) encoding.

19. A chip, wherein the chip comprises a processor and a memory, the memory and the processor are connected to each other through a line, the memory stores instructions, and the processor is configured to perform the method according to any one of claims 1 to 9.

FIG. 1

FIG. 2

Outer encoding → Padding bit insertion → Convolutional interleaving → Inner encoding → Symbol mapping and polarization distribution → Channel interleaving

FIG. 3

```
┌─────────────────────────────────────┐
│ Obtain a data stream that has        │──── 101
│ undergone first FEC encoding         │
└─────────────────────────────────────┘
                  │
┌─────────────────────────────────────┐
│ Perform bit padding on the data      │──── 102
│ stream that has undergone first FEC  │
│ encoding                             │
└─────────────────────────────────────┘
                  │
┌─────────────────────────────────────┐
│ Perform convolutional interleaving   │──── 103
│ on the data stream that has          │
│ undergone bit padding                │
└─────────────────────────────────────┘
                  │
┌─────────────────────────────────────┐
│ Perform second FEC encoding on the   │──── 104
│ data stream that has undergone       │
│ convolutional interleaving           │
└─────────────────────────────────────┘
                  │
┌─────────────────────────────────────┐
│ Perform symbol mapping and           │──── 105
│ polarization distribution on a       │
│ codeword obtained through second     │
│ FEC encoding                         │
└─────────────────────────────────────┘
                  │
┌─────────────────────────────────────┐
│ Perform channel interleaving on a    │──── 106
│ DP-16QAM symbol set                  │
└─────────────────────────────────────┘
```

FIG. 4

10970 columns

1
2
3
4

⋮

118
119

A shaded part
represents a
parity bit

⋮

10280 columns

690 columns

FIG. 5

Delay
line 0

119 bits

D D D D ... D D

30

Delay
line 1

D D ... D D

28

⋮

Delay line 13

D D D D

Delay line 14

D D

Delay line 15

FIG. 6(a)

Delay line 0

Delay line 1

Delay line 2

Delay line 14

28

119 bits

Delay line 15

30

FIG. 6(b)

EP 4 776 541 A1

FIG. 7

| $s_{0,0}$ | $s_{0,1}$ | ... | $s_{0,15}$ | $s_{0,16}$ |
|-----------|-----------|-----|------------|------------|
| $s_{1,0}$ | $s_{1,1}$ | ... | $s_{1,15}$ | $s_{1,16}$ |
| | | $\vdots$ | | |
| $s_{7,0}$ | $s_{7,1}$ | ... | $s_{7,15}$ | $s_{7,16}$ |

FIG. 8

FIG. 9

FIG. 10

Data processing apparatus

| Obtaining unit | Padding unit | Convolutional interleaving unit | Encoding unit | Mapping unit | Channel interleaving unit |
|---|---|---|---|---|---|
| 201 | 202 | 203 | 204 | 205 | 206 |

FIG. 11

Data processing apparatus

301

302

303

Processor

Transceiver

Memory

FIG. 12

## INTERNATIONAL SEARCH REPORT

| International application No. |
| --- |
| **PCT/CN2024/114419** |

| A. | CLASSIFICATION OF SUBJECT MATTER |
| --- | --- |
| | H04L 1/00(2006.01)i |

According to International Patent Classification (IPC) or to both national classification and IPC

| B. | FIELDS SEARCHED |
| --- | --- |

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

CNABS, CNTXT, VEN, WOTXT, USTXT, EPTXT, CNKI, IEEE: 级联, 前向纠错, 有限域, 伽罗华域, 伽罗瓦域, 校验, 比特, 码字, 循环冗余校验, cascade, FEC, BCH, finite field, Galois field, GF, GF(28), parity, bit, code, CRC, (136, 119)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | WO 2020228126 A1 (HUAWEI TECHNOLOGIES CO., LTD.) 19 November 2020 (2020-11-19)<br>  description, page 1, paragraph 7 to page 2, paragraph 3, page 6, paragraph 2, page 13, paragraph 3, page 13, paragraph 8, page 31, paragraphs 2 to 4, and page 33, paragraph 7 | 1, 4-5, 8-10, 13-14, 17-19 |
| A | CN 113810062 A (NANJING WINDORISE TECHNOLOGY CO., LTD.) 17 December 2021 (2021-12-17)<br>  entire document | 1-19 |
| A | CN 106603085 A (BUILDWIN SEMICONDUCTOR (SHENZHEN) CO., LTD. et al.) 26 April 2017 (2017-04-26)<br>  entire document | 1-19 |
| A | EP 2822183 A1 (SAMSUNG ELECTRONICS CO., LTD.) 07 January 2015 (2015-01-07)<br>  entire document | 1-19 |

☐ Further documents are listed in the continuation of Box C.  ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **26 November 2024** | **28 November 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/114419**

| Patent document cited in search report | | | Publication date (day/month/year) | Patent family member(s) | | | Publication date (day/month/year) |
|---|---|---|---|---|---|---|---|
| WO | 2020228126 | A1 | 19 November 2020 | US | 2022077875 | A1 | 10 March 2022 |
| | | | | BR | 112021022737 | A2 | 15 February 2022 |
| | | | | US | 2022077958 | A1 | 10 March 2022 |
| | | | | CA | 3178909 | A1 | 19 November 2020 |
| | | | | WO | 2020227976 | A1 | 19 November 2020 |
| | | | | CA | 3177569 | A1 | 19 November 2020 |
| | | | | JP | 2022533326 | A | 22 July 2022 |
| | | | | EP | 3965325 | A1 | 09 March 2022 |
| | | | | EP | 3965325 | A4 | 26 October 2022 |
| | | | | BR | 112021022883 | A2 | 04 January 2022 |
| | | | | JP | 2022533081 | A | 21 July 2022 |
| | | | | JP | 7424724 | B2 | 30 January 2024 |
| | | | | EP | 3958485 | A1 | 23 February 2022 |
| | | | | EP | 3958485 | A4 | 23 March 2022 |
| CN | 113810062 | A | 17 December 2021 | CN | 113810062 | B | 12 April 2022 |
| CN | 106603085 | A | 26 April 2017 | CN | 106603085 | B | 14 April 2020 |
| EP | 2822183 | A1 | 07 January 2015 | WO | 2015002480 | A1 | 08 January 2015 |
| | | | | US | 2015012804 | A1 | 08 January 2015 |
| | | | | US | 10382059 | B2 | 13 August 2019 |
| | | | | EP | 2822183 | B1 | 12 December 2018 |

Form PCT/ISA/210 (patent family annex) (July 2022)

**EP 4 776 541 A1**

**Patent documents cited in the description**

- CN 202311295265